# EUROPEAN PATENT SPECIFICATION

(11) **EP 0 416 128 B1**
(45) Date of publication and mention of the grant of the patent: **24.05.1995**
(21) Application number: 90904684.9
(22) Date of filing: 15.03.1990
(51) Int. Cl.: C30B 29/40

(54) **WAFER OF COMPOUND SEMICONDUCTOR**
PLÄTTCHEN AUS HALBLEITERKOMPOSIT
PLAQUETTE EN SEMI-CONDUCTEUR COMPOSITE

(30) Priority: 17.03.1989 JP 66713/89
(43) Date of publication of application: 13.03.1991
(73) Proprietor: SUMITOMO ELECTRIC INDUSTRIES LIMITED, Osaka-shi, Osaka 541 (JP)
(72) Inventor: IWASAKI, T. Osaka Works of Sumitomo Electric, Osaka-shiOsaka 554 (JP); YAMABAYASHI, N. Osaka Works of Sumitomo Electric, Osaka-shi Osaka 541 (JP); MIURA, Y. Itami Works of Sumitomo Electric, Hyogo 664 (JP)
(74) Representative: Kirschner, Klaus Dieter, Dipl.-Phys.
(86) International application number: JP9000348
(87) International publication number: WO9011391

(56) References cited:
- JP-A- 5 439 387
- JP-A-52 143 761
- JP-A-60 112 694
- JP-A-61 261 300
- US-A- 4 488 930
- JOURNAL OF APPLIED PHYSICS, vol 58, no. 3, August 1985, pages 1415-1418,Woodbury, NY, US; W.T. TSANG: "Chemical beam epitaxy of InGaAs"

## Description

### Field of the Invention

The present invention relates to a compound semiconductor epitaxial wafer in which a heteroepitaxial crystal layer is formed above a compound semiconductor single crystal substrate.

### Background of the Invention

An optical element such as a light emitting element or a photoreceptor has a structure obtained by skillfully combining regions which are different in optical and electrical properties from each other. In addition, it is necessarily prepared by an epitaxial technique since such a structure must be formed by a single crystal layer of crystals on a base of already completed crystals. Epitaxial crystals are classified into homoepitaxial crystals and heteroepitaxial crystals, depending on whether a substrate and an epitaxial layer are of the same material or of different materials.

In a conventional compound semiconductor heteroepitaxial wafer, upper, lower, left and right portions of a substrate having a diameter of two inches, for example, are cut off to shape the substrate into a rectangular configuration and thereafter epitaxial growth is made on the rectangular substrate by a liquid phase growth method or a vapor phase growth method, in consideration of technical restriction of epitaxial growth formed on the compound semiconductor substrate.

However, such a conventional rectangular epitaxial wafer has had the following problems: Namely, there has been such a problem that the thickness of a resist film applied by spin coating or the like is heterogenized at corner portions of the outer periphery in pattern formation such as photolithography such that good pattern formation cannot be achieved in these portions and the yield is reduced. Further, there has also been such a problem that the corner portions are cracked or chipped by physical impact or the like due to the rectangular configuration, and hence the yield in working is reduced.

As a method of solving such problems, it is easily conceivable that an epitaxial wafer having a circular configuration may be employed. A high yield has actually been obtained by employing a circular substrate in relation to a silicon semiconductor. However, the inventors have found that a high yield cannot be achieved by directly employing a compound semiconductor heteroepitaxial wafer having a circular configuration, dissimilarly to the silicon semiconductor. This is now described.

In a compound semiconductor, it is considerably difficult to grow single crystals of high completeness maintaining stoichiometric composition, as compared with crystals of a simple substance such as silicon. Thus, bulk crystals of a compound semiconductor are generally inferior in completeness to silicon. Namely, in a generally used substrate of a compound semiconductor having a circular configuration, defects are concentrated in its outer periphery, and the defects are propagated toward an epitaxial crystal layer if epitaxial growth is made on this portion. It has been recognized that the defects of the outer peripheral portion, particularly slips, are propagated and extend toward a wafer center portion, which is absolutely nondefective in itself, after epitaxial growth due to thermal stress and physical stress in a device working step. As to the slips, detailed description is made in J. Appl. Phys. 54(2), February 1983, p. 666 - 672, for example. The definition thereof is directed to at least ten crystal defects aligning on a straight line of 1 mm.

### Disclosure of the Invention

An object of the present invention is to provide a compound semiconductor wafer which can solve such problems of the prior art to improve the yield.

In the article "Chemical beam epitaxy of InGaAs" by W. T. Tsang in the *Journal of Applied Physics* 58 (1985) a InGaAs substrate lattice-matched to InP with a latice mismatch smaller then 10⁻³ is disclosed. The epilayer is grown by molecular beam epitaxy

Another article, namely "Epitaxie en phase liquide des composés III-V sur substrat InP" by N.T. Linh, J.-P. Hombrouck and N. Sol in Journal of Crystal Growth 31 (1975), p 204 - 209, discloses the epitaxial growth of smooth InGaAs layers on InP substrates. The smooth surface have been achieved with supercooling and step-cooling processes.

EP-A-0 229 263 discloses a method of growing quaterny or pentanary alloy semiconductors be MBE lattice-matched substrate using III-V group alloy as an active layer in opto-devices.

### Disclosure of the Invention

An object of the present invention is to provide a compound semiconductor wafer which can solve such problems of the prior art to improve the yield.

The object is achieved with a compound semiconductor epitaxial wafer according to claim 1 and 10.

A dislocation free region may not necessarily extend over the entire substrate but, if means for cutting off linkage of crystals in the heteroepitaxial crystal layer is provided as hereinafter described, a dislocation free portion may be provided in a region enclosed by this means.

Preferred embodiments of the invention are characterized in the subclaims.

According to the present invention, it is possible to provide a heteroepitaxial crystal wafer which will not transfer large crystal defects to a heteroepitaxial crystal layer formed on a substrate over the entire surface since the compound semiconductor substrate is dislocation free. Further, since the compound semiconductor substrate has a substantially circular configuration, it is possible to remarkably increase the yield without causing heterogeneity of a resist film, which has been observed in the case of employing a conventional rectangular substrate. In addition, it is simultaneously possible to obtain a device which has excellent characteristics over the entire region of a circular configuration without causing new crystal defects by thermal stress and physical stress caused by external force in an intermediate stage of working the device and with no propagation of such crystal defects.

When a compound semiconductor substrate still having crystal defects is employed, a similar effect can be attained by cutting off linkage in a heteroepitaxial layer so that no bad influence is exerted by adjacently existing crystal defects.

### Brief Description of the Drawings

Figs. 1 to 3 are front elevational views for illustrating a method of growing an epitaxial layer on a dislocation free circular substrate according to the present invention.

Fig. 1 is a front elevational view showing a state of a substrate obtained by slicing an ingot.

Fig. 2 is a front elevational view showing a state of an epitaxial wafer after heteroepitaxial growth.

Fig. 3 is a front elevational view showing a state of the substrate after pattern formation working.

Figs. 4 to 6 are front elevational views for illustrating a method of growing an epitaxial layer on a rectangular substrate in accordance with a conventional method.

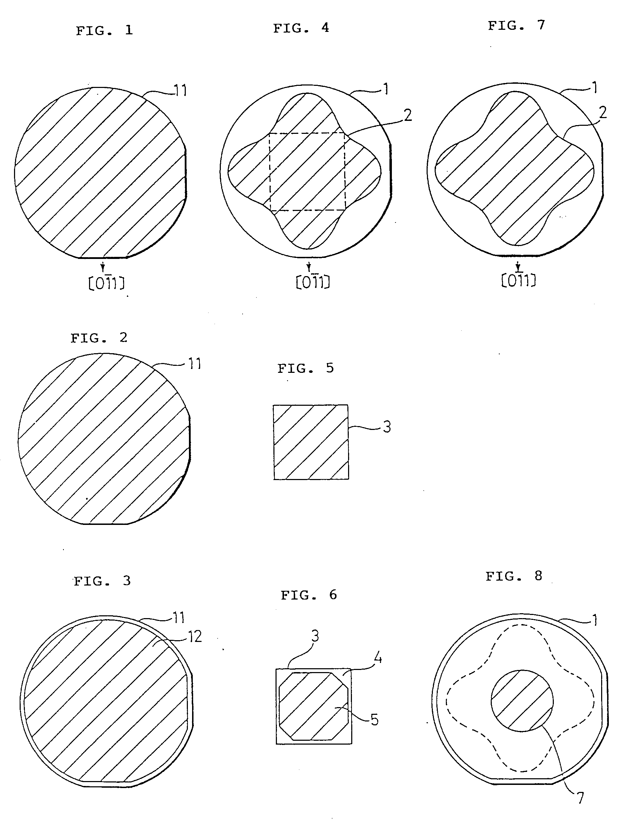

Fig. 4 is a front elevational view showing a state of a substrate obtained by slicing an ingot.

Fig. 5 is a front elevational view showing a state of an epitaxial wafer heteroepitaxially grown above a rectangular portion cut out along broken lines in Fig. 4.

Fig. 6 is a front elevational view showing a state of the substrate after pattern formation working.

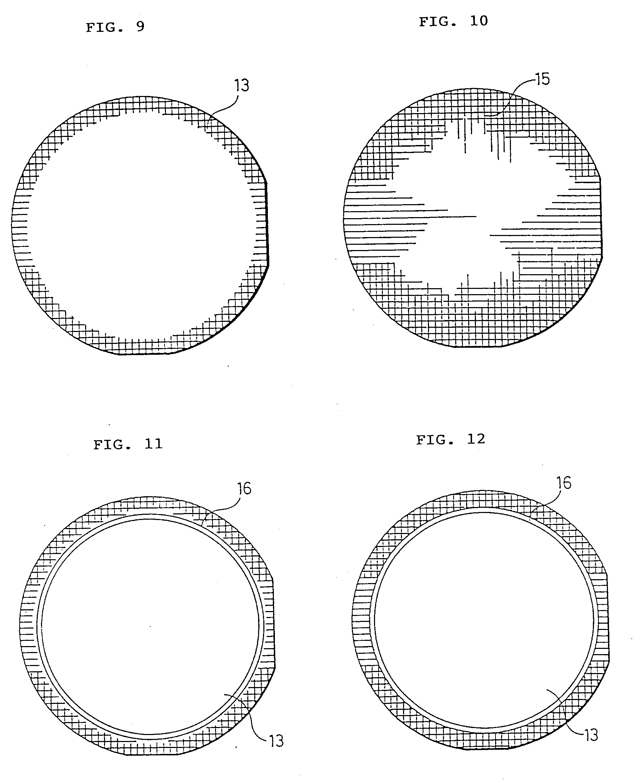

Figs. 7 and 8 are front elevational views for illustrating a comparative method of growing an epitaxial layer on a circular substrate which is not dislocation free.

Fig. 7 is a front elevational view showing a state of a substrate obtained by slicing an ingot, while a state of an epitaxial wafer after heteroepitaxial growth is similar to this.

Fig. 8 is a front elevational view showing a state of the substrate after pattern formation working.

Figs. 9 to 14 are plan views showing states of propagation of defects in the case of device-working an epitaxial wafer obtained by growing a heteroepitaxial crystal growth layer above a compound semiconductor.

Fig. 9 is a plan view showing a wafer obtained after growing a heteroepitaxial crystal layer above a compound semiconductor single crystal substrate.

Fig. 10 is a plan view showing a wafer state after device-working the wafer of Fig. 9 by a conventional method.

Fig. 11 is a plan view showing the wafer which is provided in its outer peripheral portion with means for cutting off linkage of crystals in the heteroepitaxial crystal layer in the wafer shown in Fig. 9.

Fig. 12 is a plan view showing a wafer which is provided with the means for cutting off linkage of crystals in the heteroepitaxial crystal layer of the wafer shown in Fig. 9 in the form of a lattice for enclosing every element.

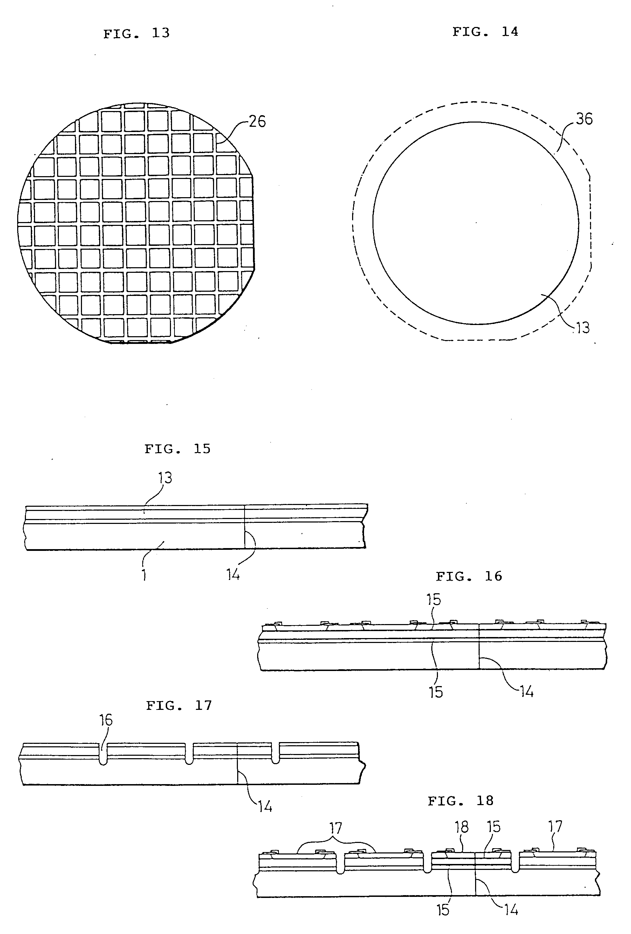

Fig. 14 is a plan view showing such a state that a portion including defects, which is the outer peripheral portion of a wafer.

Figs. 15 to 18 are sectional views showing a state of propagation of a crystal defect in the case of device-working an epitaxial wafer.

Fig. 15 is a sectional view typically showing one of crystal defects shown in the wafer of Fig. 9.

Fig. 16 is a sectional view showing propagation of the crystal defect to the epitaxial crystal layer in the wafer of Fig. 10.

Fig. 17 is a sectional view showing a section of the wafer of Fig. 13.

Fig. 18 is a sectional view showing a state of propagation of the crystal defect in the epitaxial layer after device-working the wafer of Fig. 17.

### Best Modes of Carrying Out the Invention

Before explaining Examples of the present invention, the present invention is described in further detail.

A compound semiconductor epitaxial wafer according to the present invention is characterized in that a compound semiconductor single crystal substrate, above which a heteroepitaxial crystal layer is formed, has a substantially circular configuration, and is dislocation free.

As a method of improving heterogeneity of a resist film in spin coating, it may be relatively easily conceivable to employ a substrate having a substantially circular configuration in place of the conventional rectangular substrate. However, the present invention is most characterized in that a substrate having a substantially circular configuration, which is dislocation free in addition, is employed as a substrate for forming an epitaxial crystal layer.

Namely, the inventors have found that the yield cannot be improved in the case of employing a substrate, which has a substantially circular configuration but is not dislocation free as used in general. The term dislocation free means a state including no slips (linear defects) with EPD (etch pit density; crystal defect density) of not more than 500/cm². As to the slips, detailed description is made in the aforementioned literature, and the definition thereof indicates at least ten crystal defects aligning on a straight line of 1 mm.

The present invention is adapted to improve heterogeneity caused by spin coating for improving the yield by employing a substrate having a substantially circular configuration, as well as to prevent reduction of the yield caused by propagation of defects, particularly slips, by employing a dislocation free substrate.

The above matter ia described with reference to the drawings.

Figs. 4 to 6 are front elevational views for illustrating a conventional method of growing an epitaxial crystal layer on a rectangular substrate.

Fig. 4 is a front elevational view showing a state of a substrate which is obtained by slicing a compound semiconductor single crystal ingot, such as an InP single crystal ingot, for example. The substrate plane of a circular InP single crystal substrate 1 is the (100) plane, and cleavable directions are [011] and a direction perpendicular thereto. The circular InP single crystal substrate 1 is a generally used InP single crystal substrate, and a portion including crystal defects and slips widely spread/exist in the outer peripheral portion along the [001] direction and the direction perpendicular thereto. Therefore, a dislocation free portion 2 exists in a distribution shown with oblique lines in Fig. 4. On the inside of such a dislocation free portion 2, upper, lower, left and right portions are cut off in a configuration shown by dotted lines in Fig. 4, to make a rectangular substrate. Epitaxial growth is made on this rectangular substrate. Therefore, substantially no slips have existed in the conventional rectangular substrate.

Fig. 5 is a front elevational view showing a substrate state after heteroepitaxial growth. Referring to Fig. 5, an available effective portion is shown with hatching. As shown in Fig. 5, the entire rectangular wafer 3 is substantially effective. Then a resist film is applied onto this rectangular wafer 3 by spin coating or the like, to perform pattern formation working.

Fig. 6 is a front elevational view showing a state of the substrate after pattern formation working. Referring to Fig. 6, an effective portion 5 is shown with hatching. As shown in Fig. 6, corner portions of the rectangular wafer 3 define a heterogeneous resist portion 4, and the available portion is further reduced to deteriorate the yield.

Figs. 7 and 8 are front elevational views for illustrating a method of growing an epitaxial layer on a circular substrate which is not dislocation free.

Fig. 7 is a front elevational view showing a state of a substrate which is obtained by slicing an ingot, similarly to the state of the substrate shown in Fig. 4. In this case, the substrate is not rectangularly cut out and shaped dissimilarly to the conventional method, but heteroepitaxial growth is directly made on the circular substrate. The state of the epitaxial wafer after heteroepitaxial growth is similar to that of Fig. 7 since it directly receives crystal defects of the substrate.

Fig. 8 is a front elevational view showing a state of the substrate after pattern formation working. Referring to Fig. 8, a portion with hatching shows an effective portion 7. Thus, slips in the outer peripheral portion of a circular InP single crystal substrate 1 are inwardly propagated by stress in device working, and hence the dislocation free portion is reduced.

Thus, when an epitaxial wafer provided on a circular substrate which is not dislocation free is device-worked, slips inevitably reach a portion, which has been dislocation free, after heteroepitaxial growth, and an effective portion is rather reduced to lower the yield.

Figs. 1 to 3 are front elevational views for illustrating a method of growing an epitaxial layer on a dislocation free circular substrate in accordance with the present invention.

Fig. 1 is a front elevational view showing a state of a substrate which is obtained by slicing an ingot of a compound semiconductor such as GaAs or InP etc. obtained by a VCZ method described later, for example, and a dislocation free portion is shown with hatching. As shown in Fig. 1, the dislocation free portion extends substantially over the entire region of a circular compound semiconductor single crystal substrate 11.

Fig. 2 is a front elevational view showing a state of an epitaxial wafer after being heteroepitaxially grown on the substrate 11 shown in Fig. 1. Also in Fig. 2, the dislocation free portion is shown with hatching. As shown in Fig. 2, the dislocation free portion also extends substantially over the entire region of the substrate 11 after heteroepitaxial growth.

Fig. 3 is a front elevational view showing a state of the substrate after pattern formation working, and a hatched portion shows an effective portion 13. As shown in Fig. 3, the most part of the substrate 11 defines the effective portion 12 except for a small portion in the outer periphery of the substrate 11. Thus, according to the present invention, it is possible to perform working while maintaining the effective portion of the substrate at the maximum, and the yield can be improved.

A compound semiconductor single crystal substrate, which has a substantially circular configuration and is dislocation free, employed in the present invention can be obtained by slicing an ingot obtained by a VCZ (Vapor Pressure Control Czochralski) method, for example. This VCZ method is a liquid encapsulation Czochralski method of making crystal growth in a vapor pressure of a group V element in the case of preparing group III-V compound semiconductor single crystals, for example.

In more concrete terms, the ingot is obtained in the following manner:
A vessel which can airtightly contain a high-temperature group V element is provided in the interior of a chamber employed for a Czochralski (Czochralski) method of an LEC (Liquid Encapsized Czochralski) method, while a crystal pull shaft and a rotary crucible are installed through upper and lower walls of the vessel. Clearances between the vessel and the crystal pull shaft as well as the rotary shaft of the crucible are made airtight by a liquid sealant.

A raw material contained in the crucible is molten by heating from the exterior, and a seed crystal fixed to the forward end of the crystal pull shaft is dipped in the molten solution of the raw material and pulled with rotation, thereby growing cylindrical single crystals.

Due to the pressure of the gaseous group V element stored in the vessel, no group V element is desorbed from the surfaces of the single crystals during growth thereof. In other words, no defects are caused on the basis of desorption of the group V element. At the same time, temperature difference between the crystals and the molten raw material can be reduced by the effect, whereby no defects are caused on the basis of thermal contraction stress and the defects are not more than 1/100 as compared with those by the conventional method, while it is possible to eliminate slips.

As to this VCZ method, detailed description is made in Inst. Phys. Conf. Ser. No. 91: chapter 5.

It is also possible to use single crystals obtained by a VGF (Vertical Gradient Freeze) method, which are dislocation free. This method is a method of employing already synthesized compound semiconductor single crystals as a raw material, introducing the same into a crucible and melting the same, and thereafter bringing the molten solution into contact with a seed crystal which is arranged on the lower end of the crucible to perform seeding, for upwardly growing compound semiconductor single crystals by gradually performing cooling from the lower end in a state of providing a temperature gradient in a direction perpendicular to the molten solution. As to this VGF method, description is made in J. Electrochem. Soc. Solid-State SCIENCE AND TECHNOLOGY, February 1988, Japanese Patent Laying-Open Gazette No. 63-85082 and Japanese Patent Laying-Open Gazette No. 63-274684 etc.

In the present invention, group III-V compound semiconductors such as GaAs, GaP, InSb, GaSb, and InP etc., for example, can be employed for the compound semiconductor single crystal substrate. A heteroepitaxial growth layer formed above the said compound semiconductor single crystal substrate may be grown through another crystal layer, or may be directly grown.

With respect to a GaAs substrate, for example, GaP, GaAlAs, GaAsP, InGaAlP, InAlAsP, AlAs, InGaP, InAlP, AlSbP, AlAsSbP, GaAsSbP, and GaSbP etc., can be employed for heteroepitaxial growth layers. Similarly, with respect to an InP substrate, InAlAsP, InGaAs, InGaAsP, InGaSbAs, GaSbAs, GaSbAsP, GaSbP, InAlSbAs, AlAsSb, GaAlSbAs, InAlSbP, AlSbP, AlGaSbP, InGaSbP, InSbP, AlSbP, AlGaSbP, AlGaSbP, and GaSbP etc. can be employed for heteroepitaxial growth layers.

The thickness of the heteroepitaxial crystal layer is not necessarily defined since difference in thermal expansion coefficient, difference in stress and the like are varied with combination of the material for a substrate of a compound semiconductor employed there and the crystal layer, and can be varied with the object of the final device etc.

A compound semiconductor provided with means for cutting off linkage of crystals in a heteroepitaxial crystal layer, which is a more preferred mode of the present invention, is now described.

An epitaxial wafer formed above a compound semiconductor single crystal substrate was device-worked and thereafter examined in detail, to find a portion in which elements having unpreferable photoelectric characteristics linked toward a portion close to the wafer center, which was nondefective in itself, continuously from the outer peripheral portion. The inventors considered that such a portion was caused due to the fact that crystal defects were newly caused in a working process after epitaxial growth. They considered that slips in the outer peripheral portion of the epitaxial wafer were propagated when subjected to heat treatment after device working. A layer which is most easily exposed to stress is an interface portion between heteroepitaxial layers having different thermal expansion coefficients. Therefore, a groove was formed along the outer peripheral portion for separating the outer peripheral portion, which was a portion having crystal defects, from a good portion having no crystal defects etc. after epitaxial growth, in order to prevent propagation of the slips. Such a groove is generally called a trench. When device working was performed using the wafer provided with this trench, good photoelectric characteristics were obtained in the portion enclosed by the trench, while bad influence from the outer peripheral portion of the wafer disappeared.

The aforementioned matter is described with reference to the drawings of Figs. 9 to 14 and Figs. 15 to 18.

Fig. 9 shows a wafer in a state after a heteroepitaxial crystal layer 13 is grown above a compound semiconductor single crystal substrate 1. Fig. 15 shows a section of the wafer shown in Fig. 9. As typically shown in Fig. 15, a crystal defect 14 in the substrate is transferred to the epitaxial crystal layer 13 also when this crystal layer is grown.

When a wafer having such crystal defects is device-worked, crystal defects 15 are propagated along the plane of the epitaxial crystal layer, as shown in Fig. 10. if devices are formed on such a wafer having the crystal defects 15 propagated, the crystal defects 15 cause defective chips. Fig. 16 is a sectional view showing a state of forming devices on such a wafer having crystal defects 15 propagated. As shown in Fig. 16, a defective chip 18 is caused by presence of the propagated crystal defects 15.

In a wafer provided with means 16 for cutting off linkage of crystals in a heteroepitaxial crystal layer, which is a more preferred mode of the present invention, it is possible to prevent propagation of crystal defects by this means. Fig. 11 is a plan view showing a wafer which is provided on the inside of its outer peripheral portion with a trench 16 as means for cutting off such linkage of crystals. Fig. 17 is a sectional view showing a section of such a wafer. When the wafer shown in Fig. 11 is device-worked, crystal defects 15 propagated along the plane of the crystal layer are stopped by the trench 16, which is the means for cutting off linkage of crystals, so that no crystal defects 15 are propagated toward the interior. Fig. 12 is a plan view showing such a state.

As shown in Fig. 17, such a trench 16 is preferably formed to have a depth exceeding the thickness of the epitaxial crystal layer. As shown in Fig. 18, propagation of the crystal defects 15 is prevented by formation of such a trench 16, whereby only a portion close to the crystal defects 15 defines a defective chip 18 and good chips 17 can be obtained in other regions. Thus, it is possible to remarkably improve the yield of fabrication of semiconductor chips.

Although the trench is formed along the outer peripheral portion of the wafer in the aforementioned example, such a trench may be formed in dimensions corresponding to one element of the chip. Fig. 13 shows examples of such trenches 26.

As to the means for cutting off linkage of crystals, there is also a method of completely removing a portion including defects, in addition to formation of a trench, which is a groove portion removed by etching. Fig. 14 shows a wafer from which an outer peripheral portion 36 of an epitaxial crystal layer including such defects is removed.

As to still another means, an outer peripheral portion etc. of a substrate including a large number of crystal defects may be covered with a film of SiₓN_{y}, SixOy or the like, in order to make selective growth only in a dislocation free portion.

### Example 1

A dislocation free GaAs substrate obtained by the VCZ method and a generally used substrate still having crystal defects left in its outer peripheral portion were compared and studied as follows:
Heteroepitaxial wafers were prepared by successively growing P-type AlₓGa₁₋ₓAs (x= 0.3) layers of 100 »m as first layers, P-type AlₓGa₁₋ₓAs (x = 0.02) light emitting layers as second layers, and N-type AlₓGa₁₋ₓAs (x = 0.4) layers as third layers on circular GaAs substrates of 350 »m in thickness and 75 mm in diameter.

After epitaxial growth, crystal defect distributions in the epitaxial layers and the substrates were observed through X-ray topographic observation, to recognize that crystal defects were transferred toward the N-type AlₓGa₁₋ₓAs layer, the third layer, in the conventional substrate.

On the other hand, no state of transfer of crystal defects was recognized in the dislocation free substrate.

A heteroepitaxial wafer having such a crystal structure is mainly applied to an infrared LED etc. The above heteroepitaxial wafers were employed and subjected to device working, to evaluate in-plane distributions of emission strength. In the conventional wafer, portions having low emission strength were unevenly distributed in a portion still having crystal defects left. Further, the portions having low emission strength spread toward the wafer center portion, which had no crystal defects, after epitaxial growth. In the dislocation free epitaxial wafer, on the other hand, emission strength of at least 2 mW was attained over the entire surface without depending on locations.

Then, in accordance with another mode of the present invention, the inventors removed the outer peripheral portion, still having crystal defects left, of the conventional epitaxial wafer by etching, and performed the same device working. In-plane distribution of emission strength was evaluated in the epitaxial wafer to which this technique was applied, whereby it was possible to attain emission strength of at least 2 mW over the entire surface. A sample which was device-worked while leaving crystal defects in its outer peripheral portion and that device-worked after removing the portion by etching were observed through X-ray topography respectively, to find that slips were propagated toward the wafer center portion in the former while no crystal defects were observed in any portion in the latter.

Similar phenomenons were investigated as to heteroepitaxial layers of InGaP and InGaAsP provided on GaAs substrates. Such crystal layers are employed in a short wavelength laser. Similar phenomenons were also observed as to these crystal layers, and it was recognized that the same had problems common to heteroepitaxial wafers having substrates of GaAs and the present invention is also effective as to such compound semiconductors.

### Example 2

A dislocation free InP substrate obtained by the VCZ method and a generally used substrate still having crystal defects left in its outer peripheral portion were compared and studied as follows: Circular substrates of 350 »m in thickness and 50 mm in diameter were divided into halves respectively, and the halves of the respective substrates were butted to simultaneously perform epitaxial growth thereon. The epitaxial layers were successively grown in structures of InP layers of 2 »m in thickness for first layers, InGaAs layers of 5 »m in thickness for second layers, and InP layers of 2 »m in thickness for third layers.

After the epitaxial growth, distribution states of crystal defects were observed by a method through etching, to recognize that crystal defects were transferred toward the InP layer, the third layer, through the InGaAs layer in the outer peripheral portion of the conventional InP substrate. In the dislocation free InP substrate fabricated by the VCZ method, on the other hand, no crystal defects were observed in the respective epitaxial layers. In addition, no crystal defects were observed in X-ray topographic observation. Thus, it was confirmed that the transfer of crystal defects recognized in the conventional InP substrate was not caused by epitaxial growth but the cause therefor was the InP single crystal substrate as used.

Crystals having such crystal structures are mainly applied to a long waveband light emitting element, a PIN photodiode, and the like. The aforementioned respective epitaxial wafers were employed and device-worked to measure dark currents, which are noise components, to find that portions having high dark currents were unevenly distributed in a portion still having crystal defects in the conventional wafer. Further, it was recognized that portions having high dark currents were also propagated to the wafer center portion, which had no crystal defects, after the epitaxial growth.

On the other hand, the dislocation free epitaxial wafer exhibited an excellent dark current characteristic of not more than 3 x 10⁻⁷ A/cm² in application of a voltage of -5 V over the entire surface without depending on locations. To this end, it is conceivable that slips in the outer peripheral portion of the wafer linearly extend toward the central portion in heat treatment for device working. It was recognized that the portions having high dark currents, i.e., portions in which the dark current values were at least 3 x 10⁻⁷ A/cm² in application of a voltage of -5 V, existed in extension from the outer peripheral portion of the wafer of two inches toward the central portion, in correspondence to the distribution of the crystal defects through etching observation.

In general, it was impossible to use a wafer of a circular configuration just obtained by slicing an ingot due to restriction on the epitaxial growth technique, and a rectangularly cut substrate has been employed. However, it was recognized that, even if a wafer of a circular configuration just obtained by slicing an ingot was used, portions which had been removed by cutting could not be used since crystal defects of the substrate were directly transferred to epitaxial crystal layers. It was further recognized that slips in the outer peripheral portion of the wafer were propagated toward a part of the substrate center portion having low crystal defect density and portions attaining excellent dark current characteristics were reduced as compared with the case of employing a rectangularly cut substrate as the result.

Then, a heteroepitaxial layer was removed in the form of a groove in advance of heat treatment in device working along an outer peripheral portion of an epitaxial wafer still having crystal defects left in the said portion, to form the aforementioned trench. After such formation of the trench, 5000 devices were similarly formed and in-plane distributions of dark currents were measured, to find that devices of at least 3 x 10⁻⁷ A/cm² were not more than 100 on the inside enclosed by the trench. X-ray topographic observation was simultaneously performed, to observe no crystal defects such as slips. Thus, it is possible to obtain a larger number of semiconductor devices from one wafer as compared with the prior art, to remarkably improve the yield, by forming a trench in accordance with another mode of the present invention and making epitaxial growth on a dislocation free substrate.

### Example 3

As to a dislocation free substrate obtained by the VCZ method and a generally used substrate still having crystal defects left in its outer peripheral portion, comparison and study were made as to wafers provided with heteroepitaxial layers of InGaAsP. Circular substrates of 350 »m in thickness for first layers, InGaAsP (structures of 1.3 »m in emission strength) of 1 »m for second layers and InP layers of 2 »m for third layers. After epitaxial growth, crystal defect distributions in the epitaxial layers and the substrates were observed through X-ray topography, to recognize that the conventional substrate included crystal defects toward the InP layer, the third layer.

On the other hand, no transfer of crystal defects was recognized in the dislocation free substrate. An epitaxial wafer having such a crystal structure is mainly applied to a long wavelength LED etc. The aforementioned heteroepitaxial wafers were employed and subjected to device working, to evaluate peak inverse voltages, emission strength, emission form defects and respective in-plane distributions.

In the conventional wafer, the peak inverse voltage was lowered (< 1 V) in a portion still having crystal defects left, and the emission strength was also lowered. The emission form was also defective. It was observed through X-ray topography that these crystal defects were propagated after device working toward a portion, having had no crystal defects, after heteroepitaxial growth.

In the InGaAsP heteroepitaxial layer provided on the dislocation free substrate, on the other hand, no crystal defects were observed after epitaxial growth and after device working. The peak inverse voltage was > 2 V, while the emission strength was uniform in the plane and no defect of the emission form was observed.

While nondefective devices were not more than 1000 in the conventional wafer, it was possible to obtain at least 4000 nondefective devices in the dislocation free heteroepitaxial wafer, whereby the yield was remarkably improved.

### Industrial Availability

The compound semiconductor wafer according to the present invention is applicable to a semiconductor device such as a photoreceptor such as a PIN photodiode, a laser and a light emitting element such as an LED, and an amplification element such as an FET, for example.

## Claims

1. Compound semiconductor epitaxial wafer comprising a compound semiconductor single crystal substrate and a heteroepitaxial crystal layer formed on said compound semiconductor single crystal substrate, said compound semiconductor single crystal substrate has a substantially circular configuration,
**characterized** by
- means for suppressing propagation of crystal defects to a dislocation free portion of said heteroepitaxial crystal layer,
- said suppressing means surround an area of said wafer prior to wafer processing so that defects starting outside said area during wafer processing cannot propagate into said area.

2. Compound semiconductor epitaxial wafer in accordance with claim 1, including that said compound semiconductor single crystal substrate is of a group III-V compound semiconductor, and the heteroepitaxial crystal layer formed thereon is a compound semiconductor crystal layer having a lattice constant substantially identical to the lattice constant of said group III-V compound semiconductor single crystals to such a degree that epitaxial crystal growth is possible.

3. Compound semiconductor epitaxial wafer in accordance with claim 2, including that said group III-V compound semiconductor is GaAs or InP.

4. Compound semiconductor epitaxial wafer in accordance with claim 2, wherein the compound semiconductor having a lattice constant substantially identical to the lattice constant of said group III-V compound semiconductor single crystals includes a semiconductor containing at least two elements selected from the group of Ga, As, Al, In and P.

5. A compound semiconductor epitaxial wafer in accordance with claim 3, including that said group III-V compound semiconductor is GaAs, and the heteroepitaxial crystal layer is formed of GaAlAs.

6. A compound semiconductor epitaxial wafer in accordance with claim 3, including that said group III-V compound semiconductor is GaAs, and the heteroepitaxial crystal layer is that of InGaP.

7. A compound semiconductor epitaxial wafer in accordance with claim 3, including that said group III-V compound semiconductor is GaAs, and the heteroepitaxial crystal layer is that of InGaAlP.

8. A compound semiconductor epitaxial wafer in accordance with claim 3, including that said group III-V compound semiconductor is InP, and the heteroepitaxial crystals are those of InGaAs.

9. A compound semiconductor epitaxial wafer in accordance with claim 4, including that said group III-V compound semiconductor is InP, and the heteroepitaxial crystals are those of InGaAsP.

10. Compound semiconductor epitaxial wafer comprising a compound semiconductor single crystal substrate and a heteroepitaxial crystal layer formed on said compound semiconductor single crystal substrate,
**characterized** by
- means for suppressing propagation of crystal defects to a dislocation free portion of said heteroepitaxial crystal layer,
- said suppressing means include means for cutting off crystal linkage in said heteroepitaxial crystal layer.

11. Compound semiconductor epitaxial wafer in accordance with claim 10, wherein said means for suppressing propagation of crystal defects include a groove surrounding the good portions having no crystal defects.

12. Compound semiconductor epitaxial wafer in accordance with claim 10, wherein said suppressing means for cutting off crystal linkage is a removed portion close to the outer periphery of said wafer.

13. Compound semiconductor epitaxial wafer in accordance with claim 10, **characterized** in that, said means for cutting of crystal linkage include an SiₓN_{y}, SiₓO_{y} film which covers an outer peripheral portion of said substrate, said film permitt selectively growing said heteroepitaxial crystal layer only on a dislocation free portion of the substrate.

## Patentansprüche

1. Epitaxiales Blättchen aus Halbleiterkomposit mit einem Einzelkristallsubstrat aus Halbleiterkomposit und einer heteroepitaxiale Kristallschicht, die auf dem Einzelkristallsubstrat aus Halbleiterkomposit gebildet ist, wobei das Einzelkristallsubstrat aus Halbleiterkomposit eine im wesentlichen kreisförmige Konfiguration aufweist,
**gekennzeichnet durch**
- eine Einrichtung zum unterdrücken der Ausbreitung von Kristalldefekten in einen versetzungsfreien Teil der heteroepitaxialen Kristallschicht,
- wobei die Unterdrückungseinrichtung vor der Verarbeitung des Blättchens einen Bereich des Blättchens umgibt, so daß Defekte, die von außerhalb des Bereiches während der Bearbeitung des Blättchens starten, nicht in diesen Bereich sich ausbreiten können.

2. Epitaxiales Blättchen aus Halbleiterkomposit gemäß Anspruch 1, wobei das Einzelkristallsubstrat aus Halbleiterkomposit ein Halbleiterkomposit der Gruppe III-V ist und die heteroepitaxiale Kristallschicht, die darauf gebildet ist, eine Kristallschicht aus Halbleiterkomposit ist mit einer Gitterkonstante im wesentlichen identisch zu der Gitterkonstante der Einzelkristalle aus Halbleiterkomposit der Gruppe III-V bis zu einem solchen Grad, daß eine Kristallepitaxie möglich ist.

3. Epitaxiales Blättchen aus Halbleiterkomposit gemäß Anspruch 2, wobei das Halbleiterkomposit der Gruppe III-V GaAs oder InP ist.

4. Epitaxiales Blättchen aus Halbleiterkomposit gemäß Anspruch 2, worin das Halbleiterkomposit, das eine Gitterkonstante im wesentlichen identisch zu der Gitterkonstante der Einzelkristalle aus Halbleiterkomposit der Gruppe III-V aufweist, einen Halbleiter umfaßt, welcher mindestens zwei Elemente enthält, die von der Gruppe aus Ga, As, Al, In und P gewählt sind.

5. Epitaxiales Blättchen aus Halbleiterkomposit nach Anspruch 3, wobei das Halbleiterkomposit der Gruppe III-V GaAs ist und die heteroepitaxiale Kristallschicht aus GaAlAs gebildet ist.

6. Epitaxiales Blättchen aus Halbleiterkomposit nach Anspruch 3, worin das Halbleiterkomposit der Gruppe III-V GaAs ist, und die heteroepitaxiale Kristallschicht aus InGaP ist.

7. Epitaxiales Blättchen aus Halbleiterkomposit nach Anspruch 3, worin das Halbleiterkomposit der Gruppe III-V GaAs ist und die heteroepitaxiale Kristallschicht aus InGaAlP ist.

8. Epitaxiales Blättchen aus Halbleiterkomposit gemäß Anspruch 3, worin das Halbleiterkomposit der Gruppe III-V InP ist, und die heteroepitaxialen Kristalle aus InGaAs sind.

9. Epitaxiales Blättchen aus Halbleiterkomposit nach Anspruch 4, worin das Halbleiterkomposit der Gruppe III-V aus InP ist, und die heteroepitaxialen Kristalle aus InGaAsP sind.

10. Epitaxiales Blättchen aus Halbleiterkomposit mit einem Einzelkristallsubstrat aus Halbleiterkomposit und einer heteroepitaxiale Kristallschicht, die auf dem Einzelkristallsubstrat aus Halbleiterkomposit gebildet ist,
**gekennzeichnet durch**
- Einrichtung zum Unterdrücken der Ausbreitung von Kristalldefekten in einen versetzungsfreien Teil der heteroepitaxialen Kristallschicht,
- wobei die Unterdrückungseinrichtung eine Einrichtung zum Abschneiden der Kristallverbindung in der heteroepitaxialen Kristallschicht umfaßt.

11. Epitaxiales Blättchen aus Halbleiterkomposit nach Anspruch 10, worin die Einrichtung zum Unterdrücken der Ausbreitung der Kristalldefekte eine Vertiefung umfaßt, welche die guten Teile ohne Kristalldefekte umgibt.

12. Epitaxiales Blättchen aus Halbleiterkomposit nach Anspruch 10, worin die Unterdrückungseinrichtung zum Abschneiden der Kristallverbindung einen entfernten Teil umfaßt, welcher nahe dem äußeren Rand des Blättchens liegt.

13. Epitaxiales Blättchen aus Halbleiterkomposit nach Anspruch 10, dadurch gekennzeichnet, daß die Einrichtung zum Abschneiden der Kristallverbindung einen Film aus SiₓN_{y}, SiₓO_{y} umfaßt, welcher einen äußeren Umfangsteil des Substrates abdeckt, wobei der Film ein selektives Aufwachsen der heteroepitaxialen Kristallschicht nur auf einem versetzungsfreien Teil des Substrates erlaubt.

## Revendications

1. Tranche épitaxiale de semiconducteur composé comprenant un substrat monocristallin en semiconducteur composé et une couche cristalline hétéro-épitaxiale formée sur le substrat monocristallin en semiconducteur composé, ce substrat monocristallin en semiconducteur composé ayant une configuration pratiquement circulaire,
caractérisée par
- des moyens pour empêcher la propagation de défauts cristallins vers une partie exempte de dislocations de la couche cristalline hétéro-épitaxiale,
- ces moyens empêchant la propagation entourant une zone de la tranche avant le traitement de la tranche, de façon que des défauts qui partent de l'extérieur de cette zone pendant le traitement de la tranche ne puissent pas se propager à l'intérieur de la zone.

2. Tranche épitaxiale en semiconducteur composé selon la revendication 1, dans laquelle le substrat monocristallin en semiconducteur composé consiste en un semiconducteur composé du groupe III-V et la couche cristalline hétéro-épitaxiale qui est formée sur le substrat est une couche cristalline en semiconducteur composé ayant une constante de réseau pratiquement identique à la constante de réseau des monocristaux de semiconducteur composé du groupe III-V, avec un degré de concordance tel que la croissance cristalline épitaxiale soit possible.

3. Tranche épitaxiale de semiconducteur composé selon la revendication 2, dans laquelle le semiconducteur composé du groupe III-V consiste en GaAs ou InP.

4. Tranche épitaxiale de semiconducteur composé selon la revendication 2, dans laquelle le semiconducteur composé ayant une constante de réseau pratiquement identique à la constante de réseau des monocristaux de semiconducteur composé du groupe III-V, consiste en un semiconducteur contenant au moins deux éléments sélectionnés dans le groupe qui comprend Ga, As, Al, In et P.

5. Une tranche épitaxiale de semiconducteur composé selon la revendication 3, dans laquelle le semiconducteur composé du groupe III-V consiste en GaAs, et la couche cristalline hétéro-épitaxiale consiste en GaAlAs.

6. Une tranche épitaxiale de semiconducteur composé, selon la revendication 3, dans laquelle le semiconducteur composé du groupe III-V consiste en GaAs, et la couche cristalline hétéro-épitaxiale consiste en InGaP.

7. Une tranche épitaxiale de semiconducteur composé selon la revendication 3, dans laquelle le semiconducteur composé du groupe III-V consiste en GaAs, et la couche cristalline hétéro-épitaxiale consiste en InGaAlP.

8. Une tranche épitaxiale de semiconducteur composé selon la revendication 3, dans laquelle le semiconducteur composé du groupe III-V consiste en InP, et les cristaux hétéro-épitaxiaux consistent en InGaAs.

9. Une tranche épitaxiale de semiconducteur composé selon la revendication 4, dans laquelle le semiconducteur composé du groupe III-V consiste en InP, et les cristaux hétéro-épitaxiaux consistent en InGaAsP.

10. Tranche épitaxiale de semiconducteur composé comprenant un substrat monocristallin en semiconducteur composé et une couche cristalline hétéro-épitaxiale formée sur le substrat monocristallin en semiconducteur composé,
caractérisée par
- des moyens pour empêcher la propagation de défauts cristallins vers une partie exempte de dislocations de la couche cristalline hétéro-épitaxiale,
- les moyens empêchant la propagation comprenant des moyens destinés à rompre la liaison cristalline dans la couche cristalline hétéro-épitaxiale.

11. Tranche épitaxiale de semiconducteur composé selon la revendication 10, dans laquelle les moyens destinés à empêcher la propagation de défauts cristallins comprennent un sillon entourant les bonnes parties, n'ayant pas de défauts cristallins.

12. Tranche épitaxiale de semiconducteur composé selon la revendication 10, dans laquelle les moyens destinés à empêcher la propagation en rompant la liaison cristalline consistent en une partie enlevée à promité de la périphérie extérieure de la tranche.

13. Tranche épitaxiale de semiconducteur composé selon la revendication 10, caractérisée en ce que les moyens destinés à rompre la liaison cristalline comprennent une pellicule de SiₓN_{y}, SiₓO_{y} qui couvre une partie périphérique extérieure du substrat, cette pellicule permettant la croissance sélective de la couche cristalline hétéro-épitaxiale seulement sur une partie du substrat qui est exempte de dislocations.
